# EUROPEAN PATENT APPLICATION

(11) **EP 4 475 180 A1**
(43) Date of publication of application: **11.12.2024**
(21) Application number: 23747174.3
(22) Date of filing: 31.01.2023
(51) Int. Cl.: H01L 23/36, H01L 33/64

(54) **SEMICONDUCTOR MODULE**

(30) Priority: 31.01.2022 JP 2022013589
(71) Applicant: Kyocera Corporation, Kyoto-shi, Kyoto 612-8501 (JP)
(72) Inventor: YAMAMOTO, Takashi, Kyoto-shi, Kyoto 612-8501 (JP); AKAHOSHI, Tomoyuki, Kyoto-shi, Kyoto 612-8501 (JP); TSUJINO, Saki, Kyoto-shi, Kyoto 612-8501 (JP)
(74) Representative: Viering, Jentschura & Partner mbB Patent- und Rechtsanwälte
(86) International application number: PCT/JP2023/003039
(87) International publication number: WO 2023/145964

(57) **Abstract**

A semiconductor module according to the present disclosure includes a substrate, at least one semiconductor element located on the substrate, and a heat dissipation member located above the at least one semiconductor element. In the semiconductor module according to one aspect of the present disclosure, a position of the at least one semiconductor element is shifted from a center of the substrate in a plan view of the substrate.

## Description

### TECHNICAL FIELD

The present disclosure relates to a semiconductor module.

### BACKGROUND OF INVENTION

Conventionally, known modules include a module in which an LSI (Large Scale Integration) is mounted on a substrate. Known modules also include a module in which an optical element for converting an electrical signal into an optical signal is mounted on a substrate. These so-called semiconductor modules using semiconductors may have a heat sink for cooling the semiconductor elements (see Patent Document 1).

### CITATION LIST

### PATENT LITERATURE

Patent Document 1: JP 2000-40834 A

### SUMMARY

A semiconductor module according to one aspect of the present disclosure includes a substrate, at least one semiconductor element located on the substrate, and a heat dissipation member located above the semiconductor element. In the semiconductor module according to one aspect of the present disclosure, a position of the semiconductor element is shifted from a center of the substrate in a plan view of the substrate.

### BRIEF DESCRIPTION OF THE DRAWINGS

FIG. 1 is a perspective view of a semiconductor module according to an embodiment as viewed from diagonally above.
FIG. 2 is a perspective view of the semiconductor module according to the embodiment as viewed from diagonally below.
FIG. 3 is a plan view of the semiconductor module according to the embodiment.
FIG. 4 is an enlarged plan view illustrating two optical elements close to each other among a plurality of optical elements.
FIG. 5 is an enlarged plan view illustrating two optical elements located in the vicinity of a first leg portion among the plurality of optical elements.
FIG. 6 is a view of the semiconductor module according to the embodiment as viewed from an X axis negative direction side.
FIG. 7 is a perspective view of a heat dissipation member according to the embodiment as viewed from diagonally below.
FIG. 8 is a cross-sectional view taken along VIII-VIII in FIG. 6.
FIG. 9 is a schematic enlarged view of an H portion illustrated in FIG. 8.
FIG. 10 is a perspective view of a heat dissipation member according to a first variation as viewed from diagonally below.
FIG. 11 is a perspective view of a heat dissipation member according to a second variation as viewed from diagonally below.
FIG. 12 is a view of a semiconductor module according to the second variation as viewed from an X axis negative direction side.

### DESCRIPTION OF EMBODIMENTS

Modes (hereinafter referred to as "embodiments") for implementing a semiconductor module according to the present disclosure will be described in detail below with reference to the drawings. The present disclosure is not limited by the embodiments. The embodiments can be appropriately combined provided that no contradiction in processing content arises. In the following embodiments, the same portions are denoted by the same reference signs, and redundant explanations are omitted.

In the embodiments described below, expressions such as "constant", "orthogonal", "perpendicular", and "parallel" may be used, but these expressions do not mean exactly "constant", "orthogonal", "perpendicular", and "parallel". That is, each of the expressions described above allows for deviations in, for example, manufacturing accuracy, installation accuracy, and the like.

In each of the drawings referred to below, for ease of explanation, an X-axis direction, a Y-axis direction, and a Z-axis direction that are orthogonal to each other may be defined to illustrate a rectangular coordinate system in which the Z-axis positive direction is the vertically upward direction.

The related art described above has a room for further improvement in heat dissipation efficiency of a semiconductor element. Therefore, providing a semiconductor module is expected in which the heat dissipation efficiency of the semiconductor element is improved.

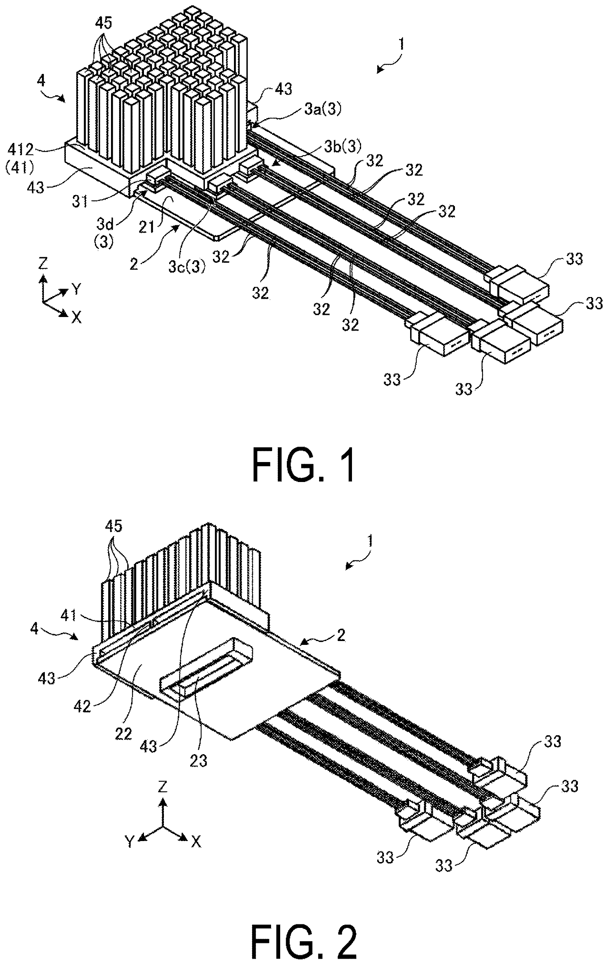

First, the overall configuration of a semiconductor module according to an embodiment will be described with reference to FIGs. 1 and 2. FIG. 1 is a perspective view of the semiconductor module according to the embodiment as viewed from diagonally above. FIG. 2 is a perspective view of the semiconductor module according to the embodiment as viewed from diagonally below.

In the embodiment described below, a case where the semiconductor module is an optical module in which optical elements are mounted on a substrate will be described as an example. Note that the semiconductor module according to the present disclosure does not necessarily need to be an optical module.

As illustrated in FIG. 1 and FIG. 2, a semiconductor module 1 according to the embodiment includes a substrate 2, a plurality of optical elements 3, and a heat dissipation member 4. The plurality of optical elements 3 include optical elements 3a to 3d.

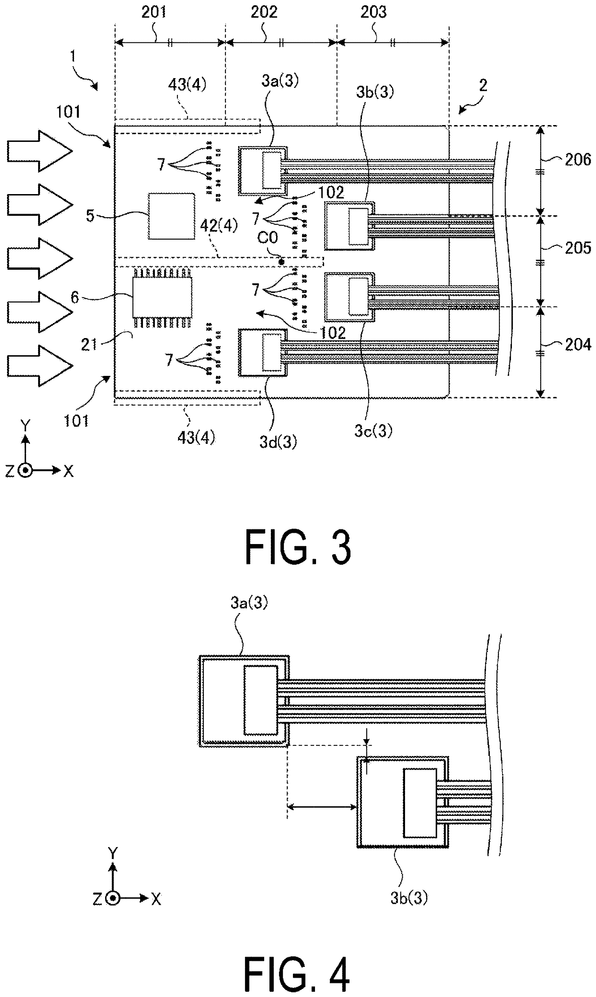

The substrate 2 has, for example, a quadrilateral plate shape in a plan view. In addition to the plurality of optical elements 3a to 3d and the heat dissipation member 4, a power supply circuit 5, a control circuit 6, a plurality of passive components 7, and the like are located on the one main surface 21 of the substrate 2. In the embodiment, the one main surface 21 of the substrate 2 is an upper surface of the substrate 2. Examples of the passive component 7 include a resistor, a capacitor, and a coil. Note that the power supply circuit 5, the control circuit 6, and the passive components 7 are illustrated in FIG. 3.

A connector 23 is located on the other main surface 22 of the substrate 2. In the embodiment, the other main surface 22 of the substrate 2 is a lower surface of the substrate 2. The substrate 2 is electrically connected to a motherboard via the connector 23.

The optical elements 3 are semiconductor elements. The optical elements 3 convert electrical signals into optical signals. Alternatively, the optical elements 3 convert optical signals into electrical signals. An interface portion 31 is located on an upper surface of each of the optical elements 3. The interface unit 31 is connected to an optical connector 33 via an optical fiber cable 32.

The heat dissipation member 4 is a so-called heat sink. The heat dissipation member 4 is located above the plurality of optical elements 3. Note that the heat dissipation member 4 does not necessarily cover all of the plurality of optical elements 3 from above. That is, as illustrated in FIG. 1, the upper surfaces of the plurality of optical elements 3 may be partially exposed from the heat dissipation member 4. The heat dissipation member 4 is close to the plurality of optical elements 3 and dissipates heat generated from the optical elements 3 to the outside of the semiconductor module 1. Note that the heat dissipation member 4 may be in contact with the optical elements 3. Alternatively, the heat dissipation member 4 may be located on the optical elements 3 via a thermal interface material (TIM). The heat dissipation member 4 may be formed of a metal having relatively high thermal conductivity, such as aluminum, copper, or iron. TIM is a composite material containing a thermally conductive filler in a resin.

The heat dissipation member 4 includes a plate-shaped portion 41, a plurality of leg portions, and a plurality of heat dissipation bodies 45. The plate-shaped portion 41 is a plate-shaped site disposed to face the substrate 2 with a gap therebetween. The plurality of leg portions include a first leg portion 42 and a second leg portion 43 which will be described below. The plurality of leg portions are provided on the plate-shaped portion 41. Specifically, the plurality of leg portions extend from the plate-shaped portion 41 toward the substrate 2 and come into contact with the substrate 2. That is, the plurality of leg portions are placed on the substrate 2. These leg portions have a shape in which the thickness is partially increased from the plate-shaped portion 41. The leg portions may be integrated with the plate-shaped portion 41. The plurality of leg portions may be connected to the plate-shaped portion 41 and the substrate 2. The plurality of leg portions extend in a certain direction. In the embodiment, the certain direction is the X axis direction. The plurality of heat dissipation bodies 45 are located on a surface 412 of the plate-shaped portion 41 on a side opposite to a facing surface 411 facing the substrate 2. Here, an example is illustrated in which the heat dissipation bodies 45 have a pin shape, that is, the heat dissipation bodies 45 are heat dissipation pins. Alternatively, the heat dissipation bodies 45 may have a plate shape, for example. That is, the heat dissipation bodies 45 may be heat dissipation fins.

FIG. 3 is a plan view of the semiconductor module 1 according to the embodiment. FIG. 4 is an enlarged plan view illustrating the two optical elements 3a and 3b close to each other among the plurality of optical elements. Note that in FIG. 3, the heat dissipation member 4 is omitted. In FIG. 3, the leg portions of the heat dissipation member 4 are illustrated by broken lines.

As illustrated in FIG. 3, when the substrate 2 is viewed in a plan view, positions of the optical elements 3 are shifted from a center C0 of the substrate 2. More specifically, the positions of all the optical elements 3a to 3d included in the semiconductor module 1 are shifted from the center C0 of the substrate 2. Here, it is assumed that the shape of the substrate 2 in a plan view is a rectangular shape such as a square or a rectangle. In this case, the center C0 of the substrate 2 is, for example, a region centered on a point at which two diagonal lines intersect each other when the two diagonal lines are virtually drawn on the surface of the substrate 2 to intersect each other. In the embodiment, when nine regions obtained by dividing the substrate 2 into three equal parts in the vertical direction and three equal parts in the horizontal direction are defined, a region located in the middle of the nine regions is defined as the region of the center C0. When the shape of the substrate 2 in a plan view is, for example, a pentagon or the like in which the position at which the diagonal lines intersect cannot be determined to be one position, the position of the center of gravity of the substrate 2 may be set to the center C0.

In this configuration, the positions of the optical elements 3 are closer to an outer peripheral portion of the substrate 2 than when the optical elements 3 are located at the center of the substrate 2. The closer the optical elements 3 are to the outer peripheral portion of the substrate 2, the more easily the optical elements 3 come into contact with the outside air. That is, the heat generated from the optical elements 3 is easily released not only from the heat dissipation member 4 but also directly from the optical elements 3 to the outside air. Therefore, the semiconductor module 1 according to the embodiment can improve the heat dissipation efficiency of the optical elements 3 as compared with the case where the optical elements 3 are located at the center of the substrate 2.

When the substrate 2 is equally divided into three regions arranged along the longitudinal direction of the leg portion in the plan view illustrated in FIG. 3, the regions are defined as a first region 201, a second region 202, and a third region 203, respectively. Note that, in the embodiment, the longitudinal direction of the leg portion is the X axis direction. The first region 201, the second region 202, and the third region 203 are arranged in this order along an X axis positive direction.

In the plan view illustrated in FIG. 3, when the substrate 2 is equally divided into three regions arranged along a direction orthogonal to the longitudinal direction of the leg portion, the regions are defined as a fourth region 204, a fifth region 205, and a sixth region 206, respectively. In the embodiment, the fourth region 204, the fifth region 205, and the sixth region 206 are arranged in this order along a Y axis positive direction.

In this case, at least a part of the optical elements 3b and 3c among the plurality of optical elements 3a to 3d is located in the third region 203. Specifically, 2/3 or more of the optical elements 3b and 3c are located in the third region 203 in the plan view illustrated in FIG. 3.

When the substrate 2 is viewed along the longitudinal direction of the leg portion, the plurality of optical elements 3a to 3d are arranged along the direction orthogonal to the longitudinal direction of the leg portion. Specifically, the plurality of optical elements 3a to 3d are arranged in the order of the optical element 3d, the optical element 3c, the optical element 3b, and the optical element 3a in the Y axis positive direction. Among the plurality of optical elements 3a to 3d, the optical element 3a is located in the sixth region 206, and the optical element 3d is located in the fourth region 204.

In this way, all of the plurality of optical elements 3a to 3d are disposed close to the outer peripheral side of the substrate 2. Specifically, at least a part of the plurality of optical elements 3a to 3d is located in an outer peripheral region when the substrate 2 is equally divided into three in the longitudinal direction of the leg portion and the direction orthogonal to the longitudinal direction, that is, a region other than a region located at the most central portion of the substrate 2. This configuration can further improve the heat dissipation efficiency of the optical elements 3a to 3d.

The plurality of optical elements 3a to 3d are located to be separated from each other. This configuration can reduce thermal interference between the optical elements 3a to 3d when the plurality of optical elements 3a to 3d are located on the substrate 2.

Specifically, as illustrated in FIG. 4, the optical element 3a and the optical element 3b located closest to the optical element 3a among the plurality of optical elements 3a to 3b are shifted from each other in the longitudinal direction of the leg portion, that is, the X axis direction, and in the direction orthogonal to the longitudinal direction of the leg portion, that is, the Y axis direction. Similarly, among the plurality of optical elements 3a to 3d, the optical element 3d and the optical element 3c located closest to the optical element 3d are shifted from each other in the X axis direction and the Y axis direction.

As described above, the plurality of optical elements 3 are arranged to be shifted from each other. Thus, in the semiconductor module 1 according to the embodiment, the size of the substrate 2 can be reduced while ensuring a distance between the optical elements 3, in other words, reducing the thermal interference between the optical elements 3.

Here, an example has been described in which two optical elements close to each other among the plurality of optical elements 3a to 3d, for example, the optical elements 3a and 3b are separated from each other in the X axis direction and the Y axis direction. Without being limited thereto, in all of the plurality of optical elements 3a to 3d, the positions of two adjacent semiconductor elements may be shifted in the longitudinal direction of the leg portion, that is, the X axis direction, and in the direction orthogonal to the longitudinal direction of the leg portion, that is, the Y axis direction.

For example, the plurality of optical elements 3a to 3d may be alternately disposed. In this configuration, a ratio of an area occupied by the optical elements 3a to 3d in a certain area of the substrate 2 increases. This can reduce the possibility that the optical elements 3 and other mounted components such as the power supply circuit 5 and the control circuit 6 are disposed close to the periphery of the leg portion. Therefore, the air around the leg portion can be made to easily flow. Note that, when the optical elements 3a to 3d are alternately arranged, widths of the two rows are preferably located within a range of a length of the optical elements 3.

At least a part of the first leg portion 42 among the plurality of leg portions of the heat dissipation member 4 is located on the center C0 of the substrate 2.

As described above, when the first leg portion 42 is located at the center C0 of the substrate 2, heat at the center C0 of the substrate 2 can be efficiently transferred to the plate-shaped portion 41 and the heat dissipation bodies 45 via the first leg portion 42. This can reduce heat accumulation at the center C0 of the substrate 2. Therefore, heat accumulated at the center C0 of the substrate 2 can be reduced from being transmitted to the optical elements 3.

The two second leg portions 43 extend along the longitudinal direction of the first leg portion 42, that is, the X axis direction, and are spaced apart from the first leg portion 42 in a direction orthogonal to the longitudinal direction of the first leg portion 42, that is, the Y axis direction. Specifically, the two second leg portions 43 are located at both ends of the substrate 2 in the direction orthogonal to the longitudinal direction of the first leg portion 42, that is, the Y axis direction.

The first leg portion 42 and the two second leg portions 43 are located across the first region 201 and the second region 202 among the first region 201, the second region 202, and the third region 203.

The semiconductor module 1 according to the embodiment includes a first opening 101 and a second opening 102 formed by the plate-shaped portion 41, the first leg portion 42, the single second leg portion 43, and the substrate 2. The first opening 101 opens to the first region 201 side, and the second opening 102 opens to the third region 203 side. Since the heat dissipation member 4 includes the two second leg portions 43, the semiconductor module 1 includes the two first openings 101 and the two second openings 102.

A blower such as a cooling fan for sending air to the semiconductor module 1 may be located outside the first openings 101, specifically, on the X axis negative direction side of the semiconductor module 1. The blower generates air flowing in the X axis positive direction. In FIG. 4, the direction of the air sent from the blower is indicated by white arrows. The air sent from the blower flows to enter the space sandwiched between the heat dissipation member 4 and the substrate 2 from the first openings 101 and escape from the second openings 102. Since the wind hits the plurality of optical elements 3 located on the second openings 102 side, the heat dissipation efficiency of the plurality of optical elements 3 can be further enhanced.

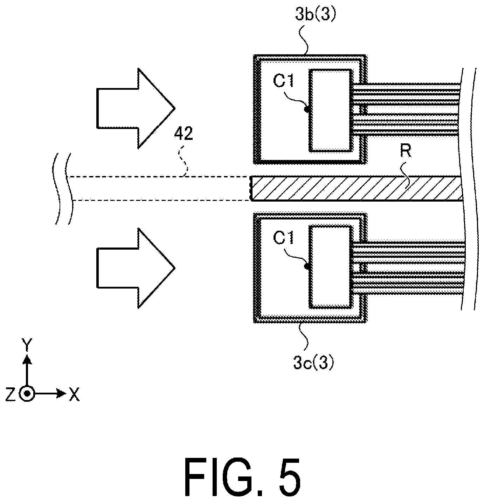

FIG. 5 is an enlarged plan view illustrating the two optical elements 3b and 3c located near the first leg portion 42 among the plurality of optical elements 3.

As illustrated in FIG. 5, when the substrate 2 is viewed in a plan view, the centers C1 of the optical elements 3b and 3c are located outside a virtual region R obtained by extending the first leg portion 42 in the longitudinal direction of the first leg portion 42, that is, the X axis direction. In this case, a width of the virtual region R, that is, a length in the direction orthogonal to the longitudinal direction of the first leg portion 42 may correspond to a width in the same direction of the first leg portion 42. The center C1 of the optical element 3b may be an intersection point of two diagonal lines which are virtually drawn on the surface of the optical element 3b to intersect with each other.

This configuration can reduce the obstruction of the air flow to the optical elements 3b and 3c by the first leg portion 42.

Note that, although FIG. 5 illustrates an example in which all of the optical elements 3b and 3c are located outside the virtual region R, when the widths of the optical elements 3b and 3c are equal to or larger than the width of the first leg portion 42, a part of the optical elements 3b and 3c may be located in the virtual region R. When the widths of the optical elements 3b and 3c are equal to or larger than the width of the first leg portion 42, the centers C1 of the optical elements 3b and 3c may be shifted from at least a virtual line extending parallel to the longitudinal direction of the first leg portion 42 and passing through the center of the first leg portion 42. Here, the widths of the optical elements 3b and 3c are the lengths of the optical elements 3b and 3c in a direction orthogonal to the longitudinal direction of the first leg portion 42.

As illustrated in FIG. 3, the centers C1 of the optical elements 3a and 3d located near the second leg portions 43 are located outside virtual regions obtained by extending the second leg portions 43 in the longitudinal directions of the second leg portions 43, that is, the X axis direction, as the same as and/or similar to the optical elements 3a and 3d. This configuration can reduce the obstruction of the air flow to the optical elements 3a and 3d by the second leg portions 43.

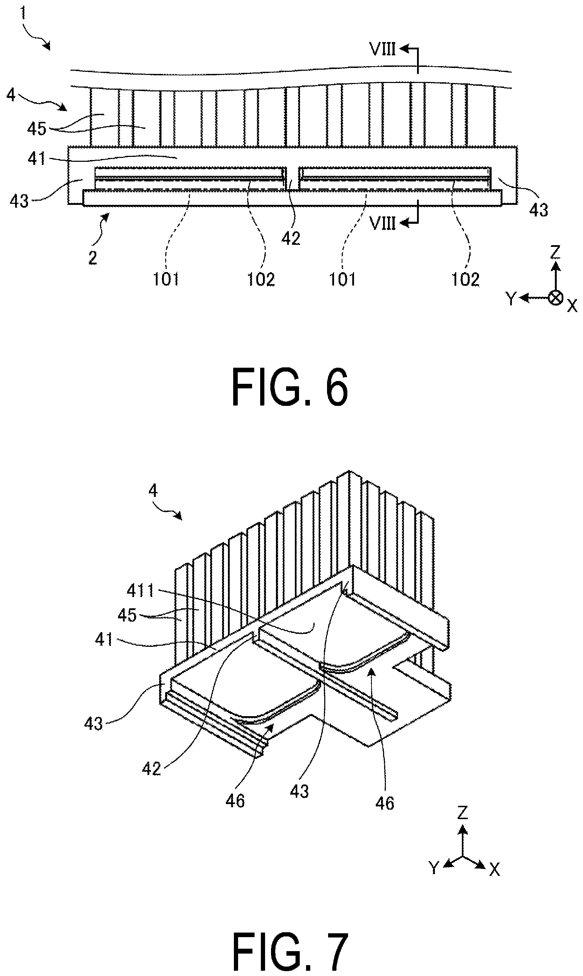

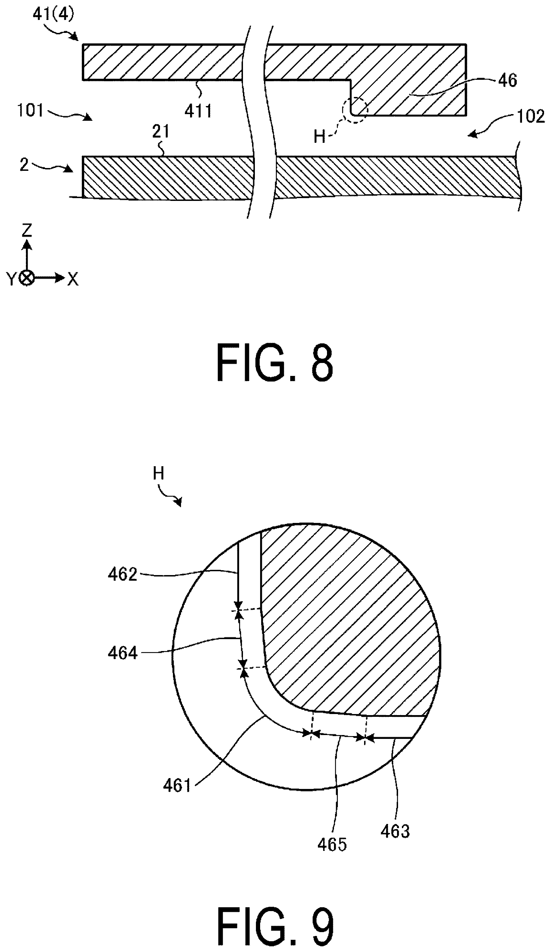

FIG. 6 is a view of the semiconductor module 1 according to the embodiment as viewed from the X axis negative direction side. FIG. 7 is a perspective view of the heat dissipation member 4 according to the embodiment as viewed from diagonally below. FIG. 8 is a cross-sectional view taken along VIII-VIII in FIG. 6. Specifically, the cross-sectional view illustrated in FIG. 8 is a side cross-sectional view of the heat dissipation member 4 taken along a plane perpendicular to the plate-shaped portion 41 and parallel to the longitudinal direction of the leg portion. Note that, for easy understanding, in FIG. 6, the first openings 101 are surrounded by a dashed line, and the second openings 102 are surrounded by an alternate long and short dashed line. In FIG. 8, the optical elements 3, the heat dissipation bodies 45, and the like are omitted.

As illustrated in FIG. 6, an opening area of the second opening 102 is smaller than an opening area of the first opening 101.

This configuration can enhance the conductance of the air flow on the second openings 102 side. That is, since the wind speed of the wind flowing in from the first openings 101 can be increased on the second openings 102 side, the heat dissipation efficiency of the plurality of optical elements 3 can be further increased.

Specifically, as illustrated in FIGs. 7 and 8, the plate-shaped portion 41 of the heat dissipation member 4 according to the embodiment includes a stepped portion 46 in which the surface on the third region 203 side is closer to the substrate 2 than the surface on the first region 201 side in the facing surface 411 facing the substrate 2. The stepped portion 46 continues to the second openings 102 and constitutes one side, here, the upper side of each of the second openings 102. Due to the stepped portion 46, the opening area of the second opening 102 is smaller than the opening area of the first opening 101. Note that, although not illustrated here, the plurality of optical elements 3 are in contact with the stepped portion 46. More specifically, the plurality of optical elements 3 are in contact with a lower surface of the stepped portion 26. A thermal conductive material (Thermal Interface Material) such as thermal conductive grease may be located between the lower surface of the stepped portion 46 and the optical elements 3.

As described above, in the semiconductor module 1 according to the embodiment, the conductance of the air flow is increased on the second openings 102 side where the plurality of optical elements 3 are disposed, and thus the heat dissipation efficiency of the plurality of optical elements 3 can be further increased.

FIG. 9 is a schematic enlarged view of the H portion illustrated in FIG. 8. As illustrated in FIG. 9, the stepped portion 46 includes a corner portion 461 curved in the cross-sectional view illustrated in FIGs. 8 and 9. As described above, since the corner portion 461 of the stepped portion 46 is curved, an air flow along the stepped portion 46 can be easily formed as compared with a case where the corner portion 461 has a right angle, for example. In other words, the air flow is less likely to be disturbed compared to the case where the corner portion 461 has a right angle. Therefore, the wind speed on the second openings 102 side can be further increased, and the heat dissipation efficiency of the plurality of optical elements 3 can be further increased.

The stepped portion 46 includes a vertical surface 462, a horizontal surface 463, a first inclined surface 464, and a second inclined surface 465. The vertical surface 462 is a surface extending vertically toward the substrate 2 from a surface on the first region 201 side of the facing surface 411 of the plate-shaped portion 41 facing the substrate 2. The horizontal surface 463 is a surface extending parallel to the substrate 2 toward the second openings 102. The first inclined surface 464 is a surface that connects the corner portion 461 and the vertical surface 462, and is inclined to be away from the first openings 101 from the vertical surface 462 toward the corner portion 461. The second inclined surface 465 is a surface that connects the corner portion 461 and the horizontal surface 463 and is inclined to approach the substrate 2 from the corner portion 461 toward the horizontal surface 463.

With this configuration, the air flow along the stepped portion 46 can be formed more easily compared to a case where the corner portion 461 has a right angle and the first inclined surface 464 and the second inclined surface 465 do not exist, for example. Therefore, the wind speed on the second openings 102 side can be further increased, and the heat dissipation efficiency of the plurality of optical elements 3 can be further increased.

### First Variation

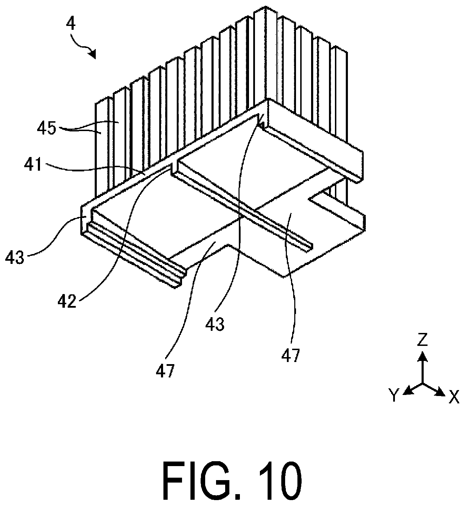

FIG. 10 is a perspective view of the heat dissipation member 4 according to a first variation as viewed from diagonally below. As illustrated in FIG. 10, the plate-shaped portion 41 of the heat dissipation member 4 may include a slope portion 47 instead of the stepped portion 46. The slope portion 47 is an inclined surface inclined to approach the one main surface 21 of the substrate 2 as approaching the second openings 102. With this configuration, the air flow is less likely to be blocked, and the opening area of the second opening 102 can be smaller than the opening area of the first opening 101.

### Second Variation

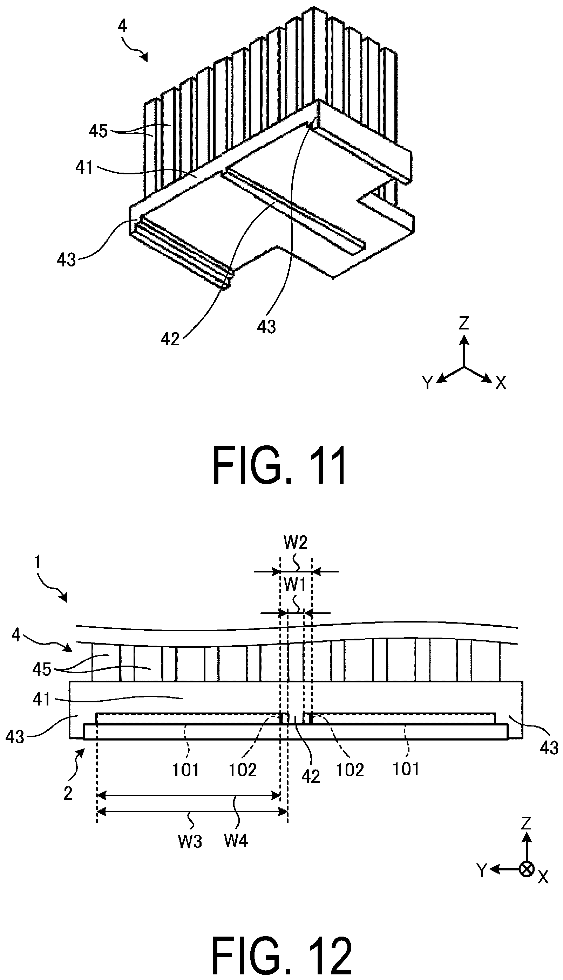

FIG. 11 is a perspective view of the heat dissipation member 4 according to a second variation as viewed from diagonally below. FIG. 12 is a view of the semiconductor module 1 according to the second variation as viewed from the X axis negative direction side.

As illustrated in FIGs. 11 and 12, the first leg portion 42 of the heat dissipation member 4 may have a shape in which the width in the direction orthogonal to the longitudinal direction of the first leg portion 42, that is, the Y axis direction increases from the first openings 101 toward the second openings 102. In this configuration, a width W2 of the first leg portion 42 on the second openings 102 side is larger than a width W1 of the first leg portion 42 on the first openings 101 side. As a result, a W4 of the second opening 102 in the direction orthogonal to the longitudinal direction of the first leg portion 42, that is, the Y axis direction is smaller than a width W3 of the first opening 101 in the same direction. That is, the opening area of the second opening 102 is smaller than the opening area of the first opening 101.

This configuration can increase the conductance of the air flow on the second openings 102 side. That is, since the wind speed of the wind flowing in from the first openings 101 can be increased on the second openings 102 side, the heat dissipation efficiency of the plurality of optical elements 3 can be further increased.

Note that, the plate-shaped portion 41 according to the second variation may include the stepped portion 46 or the slope portion 47 described above.

As described above, the semiconductor module 1 according to the embodiment includes the substrate 2, at least one semiconductor element located on the substrate, for example, the optical element 3, and the heat dissipation member 4 in contact with the semiconductor element. In the semiconductor module according to the embodiment, the position of the semiconductor element is shifted from the center C0 of the substrate in a plan view of the substrate.

Therefore, the semiconductor module according to the embodiment can improve the heat dissipation efficiency of the semiconductor elements.

Note that the embodiments disclosed herein are exemplary in all respects and not restrictive. The aforementioned embodiments can be embodied in a variety of forms. The above-described embodiments may be omitted, substituted or modified in various forms without departing from the scope and spirit of the appended claims.

The example has been given in which the widths (the lengths in the Y direction) of the first leg portion 42 and the second leg portion 43 are constant along the thickness direction (the Z axis direction), but the shapes of the first leg portion 42 and the second leg portion 43 are not limited thereto. For example, the width of the first leg portion 42 may decrease as it approaches the substrate 2.

### REFERENCE SIGNS

1 Semiconductor module
2 Substrate
3a to 3d Optical element
4 Heat dissipation member
5 Power supply circuit
6 Control circuit
7 Passive component
41 Plate-shaped portion
42 First leg portion
43 Second leg portion
45 Heat dissipation body
46 Stepped portion
47 Slope portion
101 First opening
102 Second opening
201 to 206 First region to sixth region
411 Facing surface
461 Corner portion
462 Vertical surface
463 Horizontal surface
464 First inclined surface
465 Second inclined surface

## Claims

1. A semiconductor module comprising:
a substrate;
at least one semiconductor element located on the substrate; and
a heat dissipation member located above the at least one semiconductor element, wherein
a position of the at least one semiconductor element is shifted from a center of the substrate in a plan view of the substrate.

2. The semiconductor module according to claim 1, wherein
the heat dissipation member comprises:
a plate-shaped portion spaced apart from the substrate; and
at least one leg portion extending from the plate-shaped portion toward the substrate, and
at least a part of the leg portion is located at the center of the substrate in a plan view of the substrate.

3. The semiconductor module according to claim 2, wherein
in a plan view of the substrate, at least a part of the leg portion is located in a first region and a second region among three regions obtained by equally dividing the substrate into the first region, the second region, and a third region arranged in this order along a longitudinal direction of the leg portion, and
at least a part of the at least one semiconductor element is located in the third region in a plan view of the substrate.

4. The semiconductor module according to claim 3, wherein
in a plan view of the substrate, a center of the at least one semiconductor element is located outside a virtual region obtained by extending the leg portion along the longitudinal direction of the leg portion.

5. The semiconductor module according to claim 3 or 4, comprising:
a plurality of the semiconductor elements, wherein
the plurality of semiconductor elements are arranged along a direction orthogonal to the longitudinal direction of the leg portion when the substrate is viewed along the longitudinal direction of the leg portion.

6. The semiconductor module according to claim 5, wherein
the plurality of semiconductor elements are spaced apart from each other.

7. The semiconductor module according to claim 5 or 6, wherein
the plurality of semiconductor elements comprise two of the plurality of semiconductor elements located to be shifted from each other in the longitudinal direction of the leg portion and in the direction orthogonal to the longitudinal direction of the leg portion.

8. The semiconductor module according to claim 5 or 6, wherein
in all of the plurality of semiconductor elements, positions of two of the plurality of semiconductor elements adjacent to each other are shifted in the longitudinal direction of the leg portion and in the direction orthogonal to the longitudinal direction of the leg portion.

9. The semiconductor module according to any one of claims 3 to 8, wherein
the heat dissipation member comprises a plurality of the leg portions,
the plurality of leg portions comprise
a first leg portion at least a part of which is located at the center of the substrate, and
at least one second leg portion extending along a longitudinal direction of the first leg portion and being spaced apart from the first leg portion in a direction orthogonal to the longitudinal direction of the first leg portion, and
among openings formed by the plate-shaped portion, the first leg portion, the second leg portion, and the substrate, an opening area of a second opening located on a side of the third region is smaller than an opening area of a first opening located on a side of the first region.

10. The semiconductor module according to claim 9, wherein
the plate-shaped portion comprises a stepped portion in which a surface on the side of the third region is closer to the substrate than a surface on the side of the first region in a facing surface facing the substrate.

11. The semiconductor module according to claim 10, wherein
the stepped portion continues to the second opening and constitutes one side of the second opening.

12. The semiconductor module according to claim 10 or 11, wherein
the stepped portion comprises a corner portion which is curved in a side cross-sectional view obtained by cutting the heat dissipation member in a plane perpendicular to the plate-shaped portion and parallel to the longitudinal direction of the leg portion.

13. The semiconductor module according to claim 12, wherein
the stepped portion comprises:
a vertical surface extending vertically toward the substrate from the surface on the side of the first region in the facing surface of the plate-shaped portion facing the substrate,
a horizontal surface extending parallel to the substrate toward the second opening;
a first inclined surface configured to connect the corner portion and the vertical surface, the first inclined surface being inclined away from the first opening from the vertical surface toward the corner portion; and
a second inclined surface configured to connect the corner portion and the horizontal surface, the second inclined surface being inclined to approach the substrate from the corner portion toward the horizontal surface.

14. The semiconductor module according to any one of claims 1 to 13, wherein
the at least one semiconductor element is an optical element which converts an electrical signal into an optical signal.
